# NEW EUROPEAN PATENT SPECIFICATION

(11) **EP 0 370 714 B2**
(45) Date of publication and mention of the opposition decision: **21.01.1998**
(45) Mention of the grant of the patent: 29.09.1993
(21) Application number: 89311965.1
(22) Date of filing: 20.11.1989
(51) Int. Cl.: H01Q 1/12, H03H 7/38

(54) **A wave reception apparatus for a motor vehicle**
Apparat zum Wellenempfang für einen PKW
Appareil pour la réception d'ondes pour une voiture

(30) Priority: 22.11.1988 JP 152025/88
(43) Date of publication of application: 30.05.1990
(73) Proprietor: NIPPON SHEET GLASS CO., LTD., Chuo-ku Osaka (JP)
(72) Inventor: Maeda, Masaru Nippon Sheet Glass Co. Ltd., Osaka (JP); Murakami, Harunori Nippon Sheet Glass Co. Ltd., Osaka (JP); Iijima, Hiroshi Nippon Sheet Glass Co. Ltd., Osaka (JP); Baba, Yuji Nippon Sheet Glass Co. Ltd., Osaka (JP)
(74) Representative: Jackson, David Spence

(56) References cited:
- EP-A- 146 339
- EP-A- 353 515
- EP-A- 0 079 001
- EP-A- 0 269 924
- WO-A-87/05446
- AU-B- 542 835
- GB-A- 2 019 100
- JP-A-63 121 323
- PATENT ABSTRACTS OF JAPAN, vol. 12,no. 369 (E-665)(3216), 4 October 1988;& JP-A-63121323
- G.L. Hall, The ARRL Antenna Book, The American Radio Relay League, Inc., Newington, US, 14th edition, 1984, Chapter 4: "Coupling the Transmitter to the Line", pages 4-1 to 4-11

## Description

### Background of the Invention

This invention relates to a wave reception apparatus for a motor vehicle and more particularly, to an apparatus having high sensitivity and using a low gain antenna element.

In a known system defogging heater wires and antenna conductors for receiving FM radio waves are formed on a rear window glass of a motor vehicle and are connected to each other through a stub in order to receive both AM and FM radio waves. This known system is disclosed in U.S. Patent No. 4,063,247.

The magnitude of electromotive force e₀ of AM radio waves induced within such an antenna depends upon the area of the window glass. Induced e.m.f. e₀ becomes smaller as the area of the window glass decreases.

On the contrary, the stray capacity of the antenna to ground, when the antenna is viewed from the input terminal of a tuner, does not decrease in proportion to the area of the window glass, so that if the window glass becomes small, the AM radio waves are not received well in an area where the radio field strength is rather weak. Consequently, in a recent broadcast reception system for a vehicle, the induced e.m.f. e₀ is supplied to a receiver through a preamplifier.

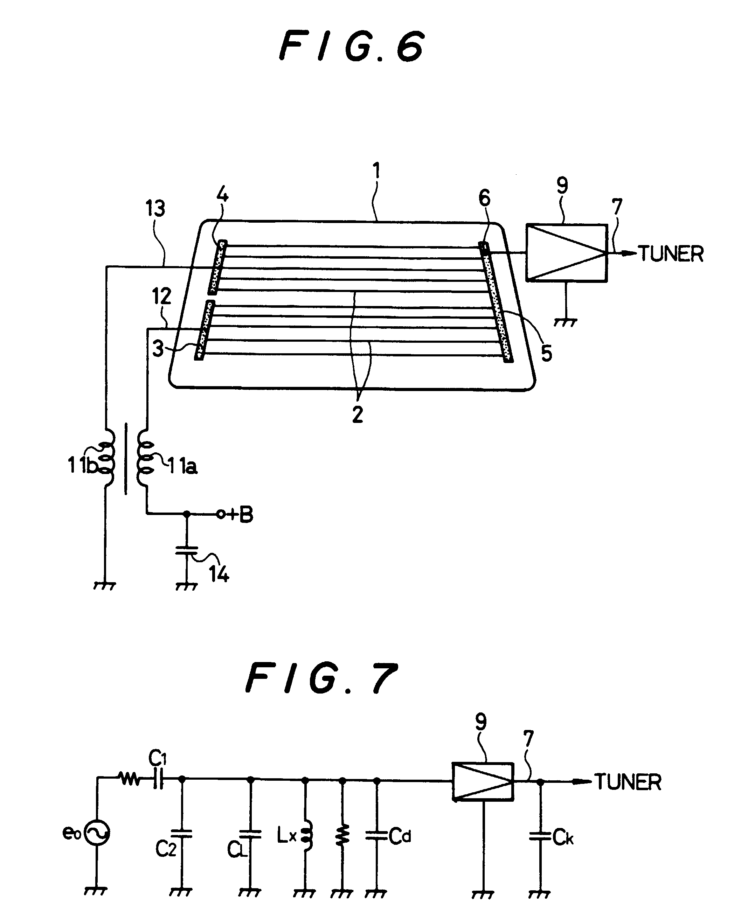

A well-known antenna pattern shown in Figure 6 comprises a plurality of defogging heater wires 2 arranged horizontally and divided into two groups, an upper group and a lower group, and the left ends of heater wires 2 are connected to buses 3 and 4. The right ends of heater wires 2 are connected to a bus 5, so that the upper group and the lower group are supplied power in series.

A feeding point 6 provided in the bus 5 is connected to a preamplifier 9. Input signals induced in the heater wires 2, which are used as an antenna for receiving the AM radio waves, are amplified by the preamplifier 9, and then fed to a tuner through a feeder cable 76, such as a coaxial cable.

A heating current to the heater wires 2 flows through choke coils 11a and 11b which are magnetically coupled with each other, and through power lines 12 and 13, and the buses 3 and 4. The choke coil 11a, connected to a power source +B, and the choke coil 11b, connected to the ground, are magnetically coupled negatively to each other, so that the core for the coils 11a and 11b is not easily saturated. A reception signal induced in the heater wires 2 is not conducted therefrom to the power source or the ground due to large impedance of the choke coils 11a and 11b in the radio wave band, which improves reception efficiency. A decoupling capacitor 14 is connected to the power source circuit, so that the reception signal is not subject to interference noises generated by the power source.

Figure 7 shows an equivalent circuit of the antenna circuit of Figure 6, and notations used in Figure 7 are as follows.
- e₀:: induced electromotive forces of the heater wires 2
- C₁ :: an active capacitance of the antenna
- C₂ :: a reactive capacitance of the antenna
- C_{L} :: a stray capacitance of the power lines 12 and 13
- Lₓ :: an equivalent inductance of the choke coils 11 a and 11b (equal to one-half of the inductance of each choke coil)
- C_{d} :: a self-capacitance of the choke coil
- Cₖ :: a stray capacitance of the feeder cable 7

As the vehicle runs, receiving conditions for the radio receiving set mounted on the vehicle vary, that is, the antenna formed on the glass of the rear window is situated in various electric field intensities. Therefore if the amplifier 9 is used to set a high reception gain, the reception signals are likely to suffer interference from noises from the amplifier 9, and noises included in the reception signals will be amplified. However, if radio waves are received near an antenna of a broadcast station, voices broadcast by the station are distorted by excessive amplification by the amplifier.

In EP-A2-0269924 there is shown an AM signal preamplifier including field-effect transistor FET through an AM signal compensation circuit including additional capacitor Cb, coil La2, capacitor Ca, and resistors Ra1 and Ra2. Band-pass filter coil La1, floating capacitor Cs, and additional capacitor Cb are used as a part of an input band-pass filter for an AM signal compensation circuit. Additional capacitor Cb tunes a frequency of an AM signal.

### Summary of the Invention

It is an object of the present invention to provide a broadcast reception apparatus for a motor vehicle in which loss in reception signals is reduced, and high sensitivity is obtained without the use of any amplifier.

According to this invention there is provided a reception apparatus for a motor vehicle which is suitable for use without any preamplification. The apparatus comprises an antenna circuit including an antenna element for supplying a reception signal to a receiver. The antenna element is a conductor formed on a surface of a window glass. A matching circuit is connected into a reception signal path of the antenna circuit and is tuned to operate within an AM broadcast band. The matching circuit comprises: an output terminal; a first inductance element connected in series to the reception signal path so as to series-resonate with a ground stray capacitance of the antenna circuit; a second inductance element connecting the antenna circuit to ground so as to parallel-resonate with the ground stray capacitance of said antenna circuit; and a resistance element connected to said second inductance element and to ground so as to compensate for a Q-factor of the parallel resonance. The second inductance element connects a connection point between said first inductance element and said output terminal to ground.

This reception apparatus needs no preamplifier.

### Brief Description of the Drawings

These and other objects and features of the invention will be seen by reference to the description, taken in connection with the accompanying drawings, in which:
Figure 1 shows a wiring diagram of an antenna circuit including heating wires formed on a rear window glass of an automobile and used as an antenna, according to an embodiment of the present invention;
Figure 2 shows an equivalent circuit of the antenna circuit;
Figure 3 is a graph showing a sensitivity of the antenna;
Figure 4 shows a front view of the rear window glass in which an antenna element is provided together with the heater wires;
Figure 5 shows a modification of the antenna circuit for reception of AM and FM radio waves, with FM radio waves amplified by a preamplifier;
Figure 6 shows a wiring diagram of a conventional antenna circuit; and
Figure 7 shows an equivalent circuit of the conventional antenna circuit.

### DESCRIPTION OF THE PREFERRED EMBODIMENT

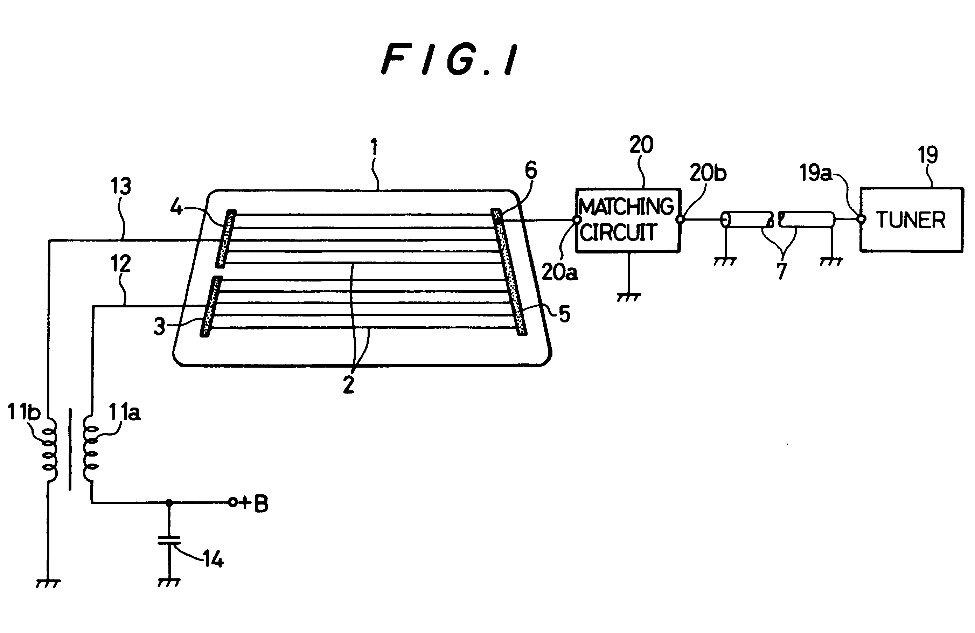

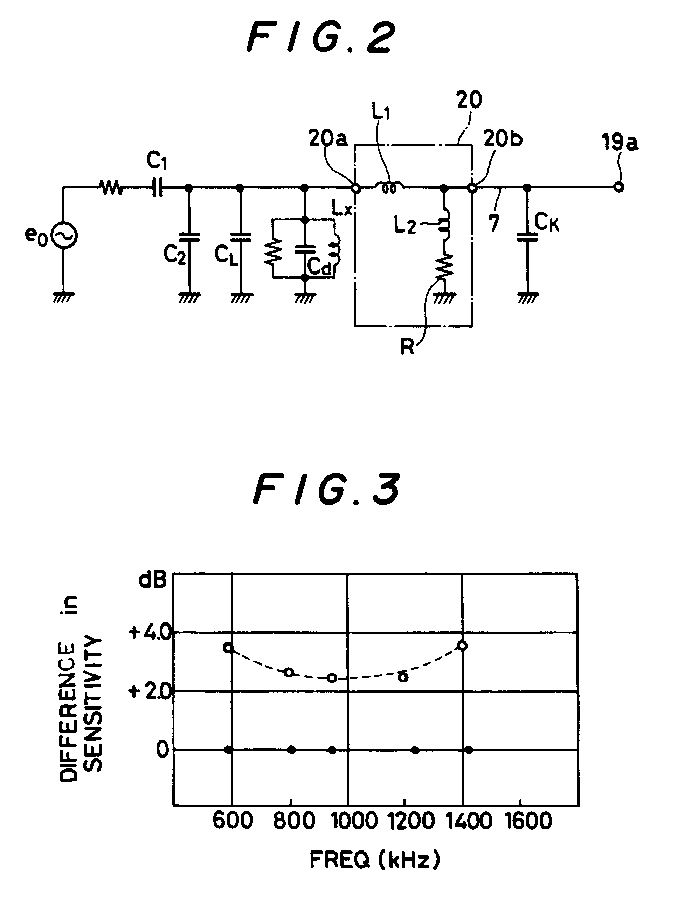

Figure 1 shows a front view of the rear window glass of an automobile and a wiring diagram of an antenna circuit, where heater wires on the rear window glass are used as an antenna element, according to an embodiment of the present invention. Figure 2 shows an equivalent circuit of that shown in Figure 1.

A conductor pattern formed on the window glass 1 is the same as that shown in Fig. 6 as well as the heating circuit of heater wires 2. In the embodiment, AM radio reception signals induced in the heater wires 2 are derived through a feeding point 6 to a matching circuit 20. The output of the matching circuit 20 is supplied to the input terminal 19a of a tuner 19 through a feeder cable 7 having a length of 3 to 4 m.

Since the preamplifier 9 in the prior art is not used, it may be a problem that reception sensitivity is low when the electric field intensity is weak. The low sensitivity of the system is caused by a stray capacitance Cₖ of the feeder cable 7, a stray capacitance C_{L} of buses 3 and 4, a self-capacitance C_{d} of choke coils 11a and 11b, and so forth shown in Figure 2, serving as reactive capacitances which make reception loss large.

In the embodiment, the matching circuit 20 is provided to improve the sensitivity of the system. As shown in Figure 2, the matching circuit 20 consists of a first coil L₁ connecting the input terminal 20a of the matching circuit 20 to the output terminal 20b of the matching circuit 20; a second coil L₂; and a damping resistor R connected in series with the second coil L₂. The series circuit consisting of the second coil L₂ and the resistor R is connected between an output end of the first coil L₁ and the ground. In other words, the first coil L₁ is connected in series with the stray capacitance of the antenna circuit to the ground. The total stray capacitance can be measured when the antenna circuit is viewed from the tuner 19. The second coil L₂ and the damping resistance R are connected in parallel with the stray capacitance.

The inductance of the second coil L₂ is fixed so as to parallel-resonate with the reactive capacitance of the antenna circuit in the AM radio band. Thus, the impedance of the antenna to the ground, measured when the antenna is viewed from the input terminal 19a of the tuner 19, increases to improve the sensitivity.

If only the coil L₂ which has a fixed inductance is connected in parallel with the reactive capacitance so as to parallel-resonate, the Q-factor becomes large, so that a range of reception frequencies which is too narrow is provided with excessive sensitivity. In the embodiment, the damping resistor R is connected in series with the second coil L₂ so as to improve the sensitivity over a wide reception bandwidth. The damping resistor R may be connected in parallel with the second coil L₂.

Further, the first coil L₁ and the reactive capacitances C₂, L_{L}, C_{d}, Cₖ and so forth form an L-type low-pass filter. When the inductance of the first coil L₁ is fixed so as to cause a sort of series-resonance with the reactive capacitance, the sensitivity is improved for the middle and high range of the reception waves.

In the equivalent circuit shown in Figure 2, respective values of the inductance of the first coil L₁, the inductance of the second coil L₂, and the resistance of the damping resistor R were fixed at 150 µH, 620 µH, and 390 Ω, for a case where the capacitance C₁ + C₂ on the window glass is 60 pF; the stray capacitance C_{L} of a power lines 12 and 13 is 40 pF; the inductance Lₓ of the choke coils 11a and 11b is 1.2 mH; the stray capacitance C_{d} of the choke coils is 19 pF; and the stray capacitance Cₖ of the feeder cable 7 is 120 pF. A good result was obtained for this example.

Figure 3 shows a difference sensitivity of AM radio wave reception in a case where the matching circuit 20 is employed, in comparison with a reference case where the matching circuit is not employed. White dots are plotted for the former case and black dots are plotted for the latter case to show a reference (0 dB).

The graph shows that sensitivity rises 2 to 4 dB in the whole range of AM radio wave when the matching circuit is employed. A reception system can be realized with sufficient gain without a preamplifier even for weak field intensity. The system produces neither noisy radio voice at a low reception intensity nor distorted radio voice at a high reception intensity. The reception system can be manufactured at less cost.

In addition, the stray capacitance can be cancelled by the matching circuit 20, so that a cable with high stray capacitance, which is economical, may be used in a path from the antenna to the tuner without degrading the sensitivity.

The impedance matching circuit 20 may be arranged at the input of tuner 19. In various arrangements, good results are obtained with values 10 to 300 µH for L₁, 200 to 1000 µH for L₂ and 100 to 700 Ω for R.

In the system shown in Figure 2, the heater wires 2 are used as an antenna for receiving AM radio waves only. When it necessary to receive AM and FM radio waves, it is preferable to connect a bypassing capacitor having a capacitance, e.g. 68 pF, in parallel with a first coil L₁ for reducing the loss of input signals induced by the FM radio waves. Alternatively, it is preferable to connect a preamplifier as mentioned later.

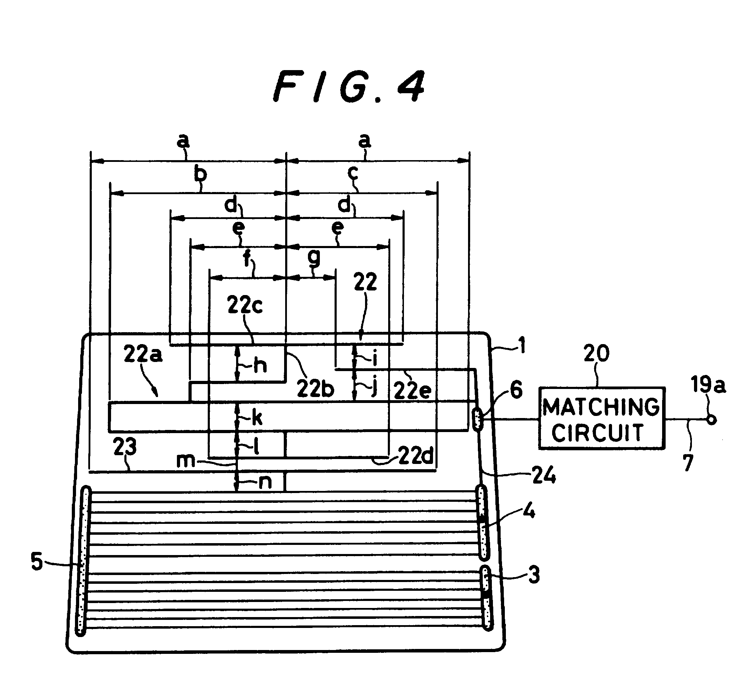

An antenna conductor pattern 22 for FM wave reception may additionally arranged on the window glass 1, as shown in Fig. 4.

The antenna pattern conductor 22 comprises a main antenna 22a consisting of two parallel conductors which are connected with each other at respective ends thereof by a conductor making a right angle with the parallel conductors; an auxiliary element 22c connected to the upper conductor of the main antenna 22a through conductors 22b; an auxiliary element 22d connected to the lower conductor of the main antenna 22a and a folded conductor 22e extending from one end of the upper conductor of the main antenna 22a. Further, an interactive element 23 connected to the upper most heater wire 2 is arranged to oppose to the lower element 22d. A conductor 24 connects the feeding point 6 to the bus 4 so as to couple the antenna conductor 22 with the heater wires 2.

In Figure 4, dimensions are given as: a = 510 mm; b = 475 mm; c = 450 mm; d = 380 mm; e = 300 mm; f = 250 mm; g = 150 mm; h = 20 mm; i = 10 mm; j = 30 mm; k = 35 mm; l = 10 mm; m = 5 mm; and n = 12 mm.

In case of the antenna shown in Figure 4, the reception signals are induced both in the heater wires 2 and in the antenna pattern 22, so that a good sensitivity is obtained in a wide bandwidth covering AM and FM broadcasts. It is not always necessary to connect the antenna pattern 22 to the heater wires 2 through the conductor 24. When the antenna pattern 22 is not directly connected, the capacitive coupling of the auxiliary element 22d with the interactive element 23 may be enhanced so as to deliver a reception signal induced in the heater wires 2 to the antenna pattern 22.

The sensitivity will be further improved, if the type and length of the cable between the antenna and the tuner are pertinently selected to reduce the inherent reactive capacitance of the antenna circuit.

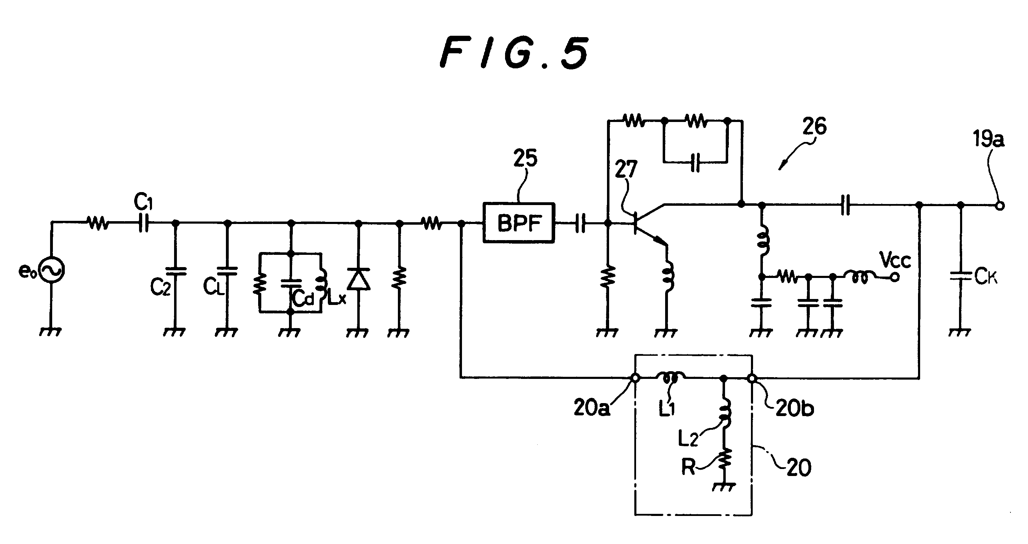

Figure 5 shows an equivalent circuit of the antenna for receiving both AM and FM radio waves. In Figure 5, a preamplifier 26 is provided in parallel with the matching circuit 20 to bypass the input and output thereof. The FM reception signals are supplied to the base electrode of a transistor 27 through a band pass filter 25 (BPF), and amplified for delivery to the tuner. According to this circuit, even when there is no area on a window glass to provide an antenna exclusively for receiving FM radio waves, high sensitivity can be attained in the whole bandwidth of the AM and FM radio waves.

According to this invention, a reception system comprises a coil element L₂ connected in parallel with the stray capacitance of the antenna circuit to the ground, measured when the antenna is viewed from the input terminal of a tuner, so as to parallel-resonate with the stray capacitance; a damping resistor for expanding the bandwidth of the parallel resonance; and a coil element L₁ constituting a L-match filter together with the stray capacitance. Impedance of the antenna circuit to ground becomes higher over a wide reception range. Thus, the signals induced in the antennas are supplied to the tuner with a small loss.

A preamplifier needs not be inserted between the antenna and the tuner. The reception system does not suffer disadvantages from the pre-amplifier which produces noisy indistinct received voices at low field intensity and distorted received voices at high field intensity. These disadvantages are removed without the reception sensitivity being degraded.

## Claims

1. A wave reception apparatus for a motor vehicle, suitable for use without any preamplification, comprising:
an antenna circuit including an antenna element (2, 22) for supplying a reception signal to a receiver (19) wherein the antenna element is a conductor formed on a surface of a window glass of the motor vehicle; and
a matching circuit (20) connected into a reception signal path of said antenna circuit wherein the matching circuit is tuned to operate within an AM broadcast band;
wherein said matching circuit comprises:
an output terminal (20b);
a first inductance element (L₁) connected in series to said.reception signal path so as to series-resonate with a ground stray capacitance (Cₖ, C₂, C_{L}, C_{d}) of said antenna circuit;
a second inductance element (L₂) connecting the antenna circuit to ground so as to parallel-resonate with said ground stray capacitance of said antenna circuit, said second inductance element (L₂) connecting a connection point between said first inductance element and said output terminal (20b) to ground ; and
a resistance element (R) connected to said second inductance element and to ground so as to compensate for a Q-factor of the parallel resonance.

2. A wave reception apparatus according to claim 1, wherein said antenna circuit comprises a feeder cable (7) for feeding the reception signal to said receiver (19);
said feeder cable (7) is connected to the output terminal (20b) of said matching circuit (20); and
said ground stray capacitance of the antenna circuit includes a capacitive component (Cₖ) of said feeder cable.

3. A wave reception apparatus according to claim 1, wherein said antenna element comprises defogging heater wires (2) formed on a rear window glass (1) of said motor vehicle.

4. A wave reception apparatus according to claim 1, wherein said antenna element comprises an antenna conductor (22) formed on a rear window glass of said motor vehicle and RF-coupled with defogging heater wires (2) formed on the rear window glass (1).

5. A wave reception apparatus according to claim 1, said matching circuit further comprising:
a bypass circuit (25, 26) tuned to operate within a FM broadcast band and arranged to bypass the matching circuit (20) for delivering an FM reception signal therethrough to said receiver (19).

6. A wave reception apparatus according to claim 5, wherein said bypass circuit comprises a series connection of a band-pass filter (25) and a preamplifier (26).

## Patentansprüche

1. Einrichtung zum Wellenempfang für ein Kraftfahrzeug, die ohne irgendeine Vorverstärkung verwendet werden kann, mit:
einer Antennenschaltung, die ein Antennenelement (2, 22) aufweist, um ein Empfangssignal zu einem Empfänger (19) zu liefern, wobei das Antennenelement als ein auf einer Oberfläche eines Fensterglases des Kraftfahrzeugs liegender Leiter ausgebildet ist; und
einer auf ein AM-Rundfunkband abgestimmten Anpassungsschaltung (20) in einem Empfangssignalweg der Antennenschaltung, wobei bei der die Anpassungsschaltung folgendes enthält:
einen Ausgangsanschluß (20b);
ein erstes induktives Element (L₁) in Serie mit dem Empfangssignalweg, um eine Serienresonanz zusammen mit einer Streukapazität (Cₖ,C₂,C_{L},C_{d}) der Antennenschaltung gegen Erde zu erhalten;
ein zweites induktives Element (L₂), über das die Antennenschaltung mit Erde verbunden ist, um eine Parallelresonanz zusammen mit der Streukapazität der Antennenschaltung gegen Erde zu erhalten, wobei das zweite induktive Element (L₂) einen zwischen dem ersten induktiven Element und dem Ausgangsanschluß (20b) liegenden Verbindungspunkt mit Erde verbindet; und
ein Widerstandselement (R) zwischen dem zweiten induktiven Element und Erde zwecks Kompensation eines Q-Faktors der Parallelresonanz.

2. Einrichtung nach Anspruch 1, bei der die Antennenschaltung ein Speisekabel (7) zum Zuführen des Empfangssignals zum Empfänger (19) aufweist; das Speisekabel (7) mit dem Ausgangsanschluß (20b) der Anpassungsschaltung (20) verbunden ist; und die Streukapazität der Antennenschaltung gegen Erde eine kapazitive Komponente (Cₖ) des Speisekabels enthält.

3. Einrichtung nach Anspruch 1, bei der das Antennenelement Beschlagentfernungs-Heizdrähte (2) enthält, die sich auf einem Heckscheibenglas (1) des Kraftfahrzeugs befinden, um ein Beschlagen zu vermeiden.

4. Einrichtung nach Anspruch 1, bei der das Antennenelement einen Antennenleiter (22) aufweist, der sich auf einem Heckscheibenglas (1) des Kraftfahrzeugs befindet und RF gekoppelt ist mit ebenfalls auf dem Heckscheibenglas (1) befindlichen Heizdrähten (2) zur Scheibenentnebelung.

5. Einrichtung nach Anspruch 1, bei der die Anpassungsschaltung ferner eine auf ein FM-Rundfunkband abgestimmte Bypass-Schaltung (25, 26) enthält, um ein FM Empfangssignal an der Anpassungsschaltung (20) vorbei zum Empfänger (19) zu liefern.

6. Einrichtung nach Anspruch 5, bei der die Bypass-Schaltung eine Serienschaltung aus einem Bandpass-Filter (25) und einem Vorverstärker (26) aufweist.

## Revendications

1. Appareil de réception d'ondes pour véhicule à moteur, conçu pour être utilisé sans aucune préamplification, comprenant :
un circuit d'antenne comportant un élément d'antenne (2, 22) servant à fournir un signal de réception à un récepteur (19), où l'élément d'antenne est un conducteur formé sur une surface d'une vitre du véhicule à moteur ; et
un circuit d'adaptation (20) connecté dans le trajet du signal de réception dudit circuit d'antenne, où le circuit d'adaptation est accordé pour fonctionner à l'intérieur d'une bande de diffusion AM ;
où ledit circuit d'adaptation comprend :
une borne de sortie (20b);
un premier élément d'inductance (L₁) connecté en série audit trajet du signal de réception de façon à être en résonance série avec une capacité parasite (Cₖ, C₂, C_{L}, C_{d}), par rapport à la terre, dudit circuit d'antenne ;
un deuxième élément d'inductance (L₂) connectant le circuit d'antenne à la terre de façon à être en résonance parallèle avec ladite capacité parasite, par rapport à la terre, dudit circuit d'antenne, ledit deuxième élément d'inductance (L₂) connectant avec la terre le point de connexion entre ledit premier élément d'inductance et ladite borne de sortie (20b) ; et
un élément de résistance R connecté audit deuxième élément d'inductance et à la terre de façon à compenser le facteur de qualité de la résonance parallèle.

2. Appareil de réception d'ondes selon la revendication 1, où :
ledit circuit d'antenne comprend un câble formant une ligne d'antenne (7), qui sert à fournir le signal de réception audit récepteur (19) ;
ledit câble (7) formant une ligne d'antenne est connecté à la borne de sortie (20b) dudit circuit d'adaptation (20) ; et
ladite capacité parasite, par rapport à la terre, du circuit d'antenne comporte une composante capacitive (Cₖ) dudit câble formant une ligne d'antenne.

3. Appareil de réception d'ondes selon la revendication 1, où ledit élément d'antenne comprend des fils chauffants de dégivrage (2) formés sur la vitre (1) de la lunette arrière dudit véhicule à moteur.

4. Appareil de réception d'ondes selon la revendication 1, où ledit élément d'antenne comprend un conducteur d'antenne (22) formé sur la vitre de la lunette arrière dudit véhicule à moteur et placé en couplage RF avec des fils chauffants de dégivrage (2) formés sur la vitre (1) de la lunette arrière.

5. Appareil de réception d'ondes selon la revendication 1, ledit circuit d'adaptation comprenant en outre :
un circuit de dérivation (25, 26) accordé de façon à fonctionner à l'intérieur d'une bande de radiodiffusion FM et disposé de manière à dériver le circuit d'adaptation (20) afin de délivrer un signal de réception FM par son intermédiaire audit récepteur (19).

6. Appareil de réception d'ondes selon la revendication 5, où ledit circuit de dérivation comprend la connexion en série d'un filtre passe-bande (25) et d'un préamplificateur (26).
